Europäisches Patentamt

European Patent Office

Office européen des brevets

(19)

(11) Veröffentlichungsnummer: **0 087 153**
**B1**

(12) **EUROPÄISCHE PATENTSCHRIFT**

(45) Veröffentlichungstag der Patentschrift: **11.02.87**

(21) Anmeldenummer: **83101651.4**

(22) Anmeldetag: **21.02.83**

(51) Int. Cl.⁴: **H 03 K 17/62**, H 03 K 5/06,
H 03 K 19/086

(54) **Digitalsignal-Multiplexer für hohe Datenraten.**

(30) Priorität: **23.02.82 DE 3206476**

(43) Veröffentlichungstag der Anmeldung:
**31.08.83 Patentblatt 83/35**

(45) Bekanntmachung des Hinweises auf die
Patenterteilung:
**11.02.87 Patentblatt 87/07**

(84) Benannte Vertragsstaaten:
**AT CH DE FR IT LI**

(56) Entgegenhaltungen:
**DE-A-2 009 010**
**US-A-3 760 109**

**IEEE JOURNAL OF SOLID-STATE CIRCUITS,**
**Band SC-14, Nr. 5, Oktober 1979 New York J.B.**
**HUGHES et al. "A versatile ECL multiplexer**
**ICfor the Gbit/s range" Seiten 812-817**
**U. TIETZE et al. "Halbleiter-Schaltungstechnik"**
**2. Auflage 1971 SPRINGER-VERLAG, Berlin-**
**Heidelberg-New-York Seiten 466, 467**
**K. Euler et al. "Pulstechnik", Band II, 1976,**
**Springer-Verlag, Berlin, Seiten 14, 15.**

(73) Patentinhaber: **Siemens Aktiengesellschaft**
**Berlin und München**
**Wittelsbacherplatz 2**
**D-8000 München 2 (DE)**

(72) Erfinder: **Gasser, Kurt**
**Lochhamer Strasse 22**
**D-8032 Gräfelfing (DE)**

Courier Press, Leamington Spa, England.

EP 0 087 153 B1

## Beschreibung

Die Erfindung betrifft einen Digitalsignal-Multiplexer für hohe Datenraten mit UND-Gattern, deren Eingängen jeweils ein Datensignal Zugeführt wird und deren zweiten Eingängen phasenverschobene Takte zum Druchschalten der Datensignale zugeführt sind, und mit einem ODER-Gatter, dessen Eingängen die Ausgangssignale der UND-Gatter zugeführt sind.

Es sind zahlreiche Multiplexer bekannt, bei denen mehrere binäre Digitalsignale über UND-ODER-Verknüpfungen zu einem Multiplexsignal zusammengefaßt werden, Bei hohen Datenraten von beispielsweise 560 Mbit/s ist eine Realisierung des Multiplexers mit den bisher üblichen Logikelementen nicht mehr möglich. Es müssen daher spezielle Logikelemente mit extrem kurzen Laufzeiten verwendet werden, die einen extrem hohen Stomverbrauch aufweisen. Die Laufzeittoleranzen dieser Logikelemente liegen in der Größenordnung ihrer Laufzeit, wodurch ihr Verwendbarkeit wiederum sehr stark eingeschränkt ist.

Aus dem IEEE Journal of Solid-State Circuits, Vol SC-14, No. 5, Okt, 1979, Seiten 812 bis 817 ist ein in ECL-Technik ausgeführter Multiplexer für hohe Datenraten bekannt, der für zeitliche Steuerung das "Traveling Wave Concept" verwendet. Mit Hilfe einer ringförmigen Anordnung von Widerständen und von Schalttransistoren werden phasenverschobene Takte zum Durchschalten der zu multiplexenden Datensignale an den Ausgang des Multiplexers erzeugt.

Aus dem Buch "Pulstechnik", Band II, von Hölzler und Holzwarth, Springer-Verlag, 1976, Seiten 14 und 15 sind Schaltungen zur Impulsformung mit kurzgeschlossenen und offenen elektrischen Leitungen bekannt.

In der US PS 3 631 266 ist eine Schaltungsanordnung eines Puls-Generators beschrieben, der eine am Ende kurzgeschlossene Verzögerungsleitung im Emitterkreis eines Transistors zur Erzeugung von Impulsen konstanter Länge verwendet.

Aufgabe der Erfindung ist es, einen Digitalsignal - Multiplexer mit einfacher Schaltungsanordnung für hohe Datenraten anzugeben.

Ausgehend vom eingangs angegebenen Stand der Technik wird diese Aufgage erfindungsgemäß dadurch gelöst, daß zwischen den Ausgängen der UND-Gatter und den Eingängen des ODER-Gatters jeweils ein Impulsformernetzwerk mit einem ohmschen Widerstand und einer elektrischen Leitung vorgesehen ist, deren Wellenwiderstand betragsmäßig dem Widerstand des ohmschen Widerstandes entspricht,

daß jeweils die Eingangsanschlüsse der elektrischen Leitung in Serie oder parallel zu dem ohmschen Widerstand geschaltet sind,

daß die Ausgansanschlüsse der elektrischen Leitung offen oder kurzgeschlossen sind

und daß digitale Impulse einer vorgegebenen Dauer am Ausgang des Impulsformernetzwerks durch Überlagerung eines Eingangsimpulses und eines am Ende der elektrischen Leitung reflektierten Impulses erzeugt werden, wobei die Länge der elektrischen Leitung die Aauer der digitalen Impulse bestimmt.

Bei dieser Ausführungsform eines Multiplexers ist es besonders vorteilhaft, daß die Länge der zu multiplexenden Impulse von einem Widerstand und einer elektrischen Leitung bestimmt werden. Die mechanische Länge der elektrischen Leitung bestimmt die Dauer des erzeugten digitalen Impulses. Je nach gewählter Anordnung des ohmschen Widerstandes und der elektrischen Leitung ergibt sich an deren Ausgang für eine positive Flanke ein positiver und für eine negative Flanke ein negativer Impuls. Durch die Lage der ODER-Gatter-Schaltschwelle wird bestimmt, ob der positive oder negative Impuls zum Ausgang durchgeschaltet wird. Das ODER-Gatter soll eine möglichst konstante Schwelle für die Eingangssignale aufweisen. Es ist selbstverständlich, daß die an den UND-Gattern liegenden Takte zum Durchschalten der Digitalsignale länger sind als ein Bit am Ausgang des Multiplexers.

Es ist zweckmäßig, daß als Impulsformernetzwerk zur Erzeugung von digitalen Impulsen einer vorgegebenen Länge eine Reihenschaltung eines Widerstandes und einer an ihrem Ausgang kurzgeschlossenen elektrischen Leitung vorgesehen ist.

Diese Schaltungsanordnung eignet sich besonders für UND-Gatter mit einem niederohmigen Ausgang, wie beispielsweise bei der ECL-Technik. Der erzeugte Impuls wird vorteilhafter Weise ander elektrischen Leitung abgenommen. Bei jeder positiven Flanke des Eingangsimpulses wird ein positiver Impuls definierter Länge an der elektrischen Leitung anliegen; bei jeder negativen Flanke des Eingangsimpulses wird ein negativer Impuls erzeugt.

Es ist grundsätzlich auch möglich, am ohmschen Widerstand einen elektrischen Impuls abzugreifen. Abhängig von der elektrischen Schwelle des nachfolgenden ODER-Gatters ergeben sich unterschiedliche Lösungsmöglichkeiten.

Bei einer hochohmigen Ansteuerung des Impulsformernetzwerks ist es zweckmäßig, daß als Impulsformernetzwerk zur Erzeugung von digitalen Impulsen einer vorgegebenen Länge die Reihenschaltung einer an ihrem Ausgang offenen elektrischen Leitung und eines ohmschen Widerstandes vorgesehen ist.

Diese Schaltungsanordnung ist gleichwertig mit der Reihenschaltung des ohmschen Widerstandes und der elektrischen Leitung. Allein die Spannungsquelle wurde durch eine Stromquellle ersetzt.

Es ist vorteilhaft, daß bei einem hochohmigen Ausgang des UND-Gatters als Impulsformernetzwerk zur Erzeugung von digitalen Impulsen einer vorgegebenen Länge eine Parallelschaltung eines Widerstandes und einer an ihrem Ausgang kurzgeschlossenen oder offenen elektrischen Leitung vorgesehen ist.

Zu dem bereits angegebenen Impulsformernetzwerk mit einem ohmschen Widerstand und einer an ihrem Ausgang kurzgeschlossenen elektrischen Leitung können duale Schaltungsanordnungen mit einer an ihrem Ausgang offenen elektrischen Leitung verwendet werden.

Es ist zweckmäßig, daß als elektrische Leitung eine Koaxialleitung vorgesehen ist.

Da die elektrischen Eigenschaften einer Koaxialleitung eingen Toleranzen unterworfen sind, kann diese durch Festlegung einer bestimmeten Länge exakt abgeglichen werden. und dadurch die Impulsdauer genau festgelegt werden.

Es ist zweckmäßig, daß als elektrische Leitung eine bifilar gewickelte Spule vorgesehen ist.

Die Verwendung einer bifilar gewickelten Spule stellt eine besonders platzsparende Realisierung der elektrischen Leitung dar.

Weitere vorteilhafte Ausbildungen der Erfindung sind in den übrigen Unteransprüchen angegeben.

Ein Ausführungsbeispiel der Erfindung und mehrere Schaltungsanordnungen zur Erzeugung von elektrischen Impulsen werden anhand der Figuren 1 bis 10 näher erläutert.
Es zeigen:

Fig. 1 einen erfindungsgemäßen Multiplexer,

Fig. 2 eine Reihenschaltung aus einem ohmschen Widerstand und einer kurzgeschlossenen elektrischen Leitung,

Fig. 3 eine Parallelschaltung des ohmschen Widerstandes mit der kurzgeschlossenen elektrischen Leitung,

Fig. 4 eine Reihenschaltung einer offenen elektrischen Leitung und eines ohmschen Widerstandes,

Fig. 5 Zeitdiagramme zum Schaltbild des Multiplexers,

Fig. 6 eine Anordnung zur Erzeugung eines AMI-Codes,

Fig. 7 eine Schaltungsanordnung zur Erzeugung eines differentiell-binären Codes,

Fig. 8 eine Logikschaltung zur Erzeugung eines differentiell-binären Codes,

Fig. 9 eine Schaltung des verwendeten ODER-Gatters und

Fig. 10 ein Spannungsdiagramm zur Erläuterung der Funktion des ODER-Gatters.

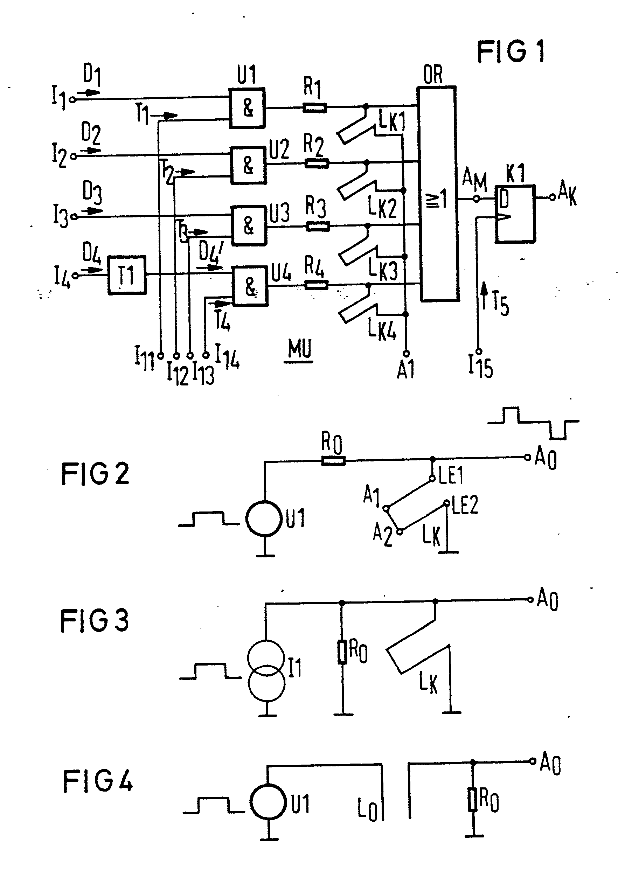

In Fig. 1 ist ein Multiplexer MU für vier digitale Datensignale $D_1$ bis $D_4$ dargestellt. Die vier Eingänge des Multiplexers MU sind mit $I_1$ bis $I_4$ bezeichnet. Jeweils ein Eingang $I_1$ bis $I_4$ ist mit einem UND-Gatter U1 bis U4 verbunden. Dem Eingang des UND-Gatters U4 ist ein Verzögerungsglied T1 vorgeschaltet. Jeweils ein zweiter Eingang jedes UND-Gatters ist mit einem Takteingang $I_{11}$ bis $I_{14}$ verbunden. Über eine Schaltungsanordnung zur Erzeugung von Impulsen einer vorgegebenen Länge sind die Ausgänge der UND-Gatter U1 bis U4 mit den Eingängen eines ODER-Gatters OR verbunden. Die Schaltungsanordnung zum Erzeugen von elektrischen Impulsen einer genau definierten Länge besteht aus jeweils einem Widerstand $R_1$

bis $R_4$ der jeweils zwischen dem Ausgang eines UND-Gatters und einem Eingang des ODER-Gatters OR eingeschaltet ist, und einer an ihrem Ausgang kurzgeschlossenen Leitung $L_{K1}$ bis $L_{K4}$. Während jeweils der erste Eingang jeder elektrischen Leitung $L_{K1}$ bis $L_{K4}$ an einen Eingang des ODER-Gatters OR angeschaltet ist, sind jeweils die zweiten Eingänge der elektrischen Leitungen $L_{K1}$ bis $L_{K4}$ zusammengefaßt und auf einen Anschlußpunkt A1 geführt. Der Ausgang $A_M$ des ODER-Gatters OR ist mit dem D-Eingang einer ersten Kippstufe K1 verbunden, deren Ausgang mit $A_K$ bezeichnet ist. $A_K$ bildet den Ausgang des Multiplexers MU. $I_{15}$ ist der Takteingang der ersten Kippstufe K1.

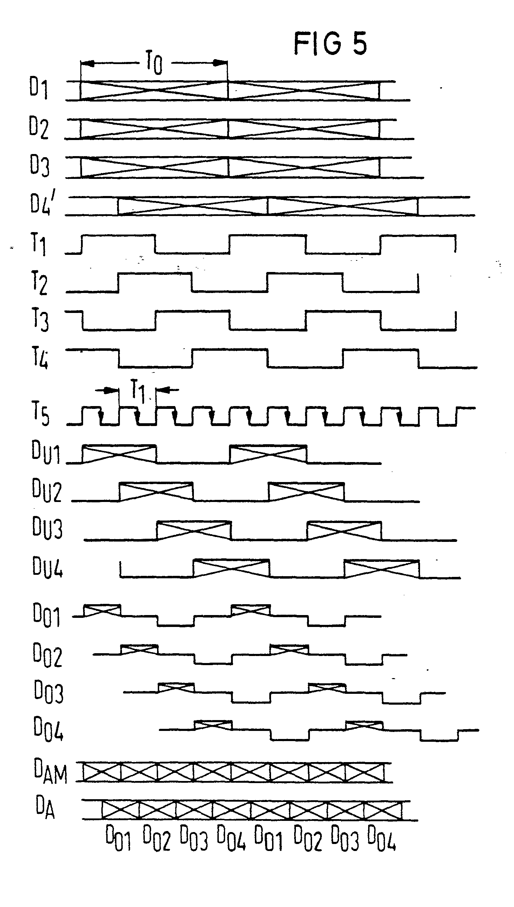

Der Multiplexer MU faßt vier an den Eingängen $I_1$ bis $I_4$ anliegende Binäre Digitalsignale $D_1$ bis $D_4$ zu einem Multiplexsignal zusammen. Bevor weitere Einzelheiten des Multiplexers anhand der in Fig. 5 dargestellten Zeitdiagramme erläutert werden, sollen zunächst verschiedene Möglichkeiten zur Erzeugung von elektrischen Impulsen einer exakt vorgegebenen Zeitdauer beschrienen werden, die an sich aus der Literatur bekannt sind.

In Fig. 2 ist das in dem Multiplexer nach Fig. 1 verwendete Impulsformernetzerk nochmals prinzipiell dargestellt. Eine Spannungsquelle U1 gibt einen positiven Eingangsimpuls ab, der einer logischen 1 des Digitalsignals entspricht. Diese Spannungsquelle U1 arbeitet auf die Reihenschaltung eines Widerstandes $R_0$ und einer an ihrem Ausgan kurzgeschlossenen Leitung $L_K$, deren erster Eingangsanschluß LE1 an den Widerstand $R_0$ angeschaltet ist und deren zweiter Eingang LE2 wechselspannungsmäßig, wie auch die Spannungsquelle U1, an Masse liegt. Die Ausgangsanschlusse $A_1$ und $A_2$ der elektrischen Leitung $L_K$ sind miteinander verbunden; die elektrische Leitung $L_K$ wird deshalb auch als "kurzgeschlossene Leitung" bezeichnet. Der erste Eingangsanschlus LE1 der elektrischen Leitung der mit dem Ausgang des Widerstandes $R_0$ verbunden ist, bildet auch gleichzeitig den Ausgang $A_0$ dieser Schaltungsanordnung. Der Wellenwiderstand der elektrischen Leitung $L_K$ entspricht dem Widerstandswert des ohmschen Widerstandes $R_0$.

Wird nun ein positiver Eingangsimpuls mit einer steilen Flanke von der Spannungsquelle U1 abgegeben, so wird zunächst am Ausgang $A_0$ durch die Spannungsteilung von $R_0$ und $L_K$ die halbe positive Spannung des Eingangsimpulses anliegen. Nach einer von den Eigenschaftung der elektrischen Leitung $L_K$, vor allem von deren Länge, abhängigen Laufzeit wird der elektrische Impuls an den kurzgeschlossenen Ausgangsanschlussen $A_1$, $A_2$ der elektrischen Leitung $L_K$ mit umgekehrten Vorzeichen reflektiert. Erreicht der reflektierte Impuls wiederum die Eingangsanschlüsse LE1, LE2 der elektrischen Leitung $L_K$, so addiert er sich zu dem noch anliegenden Impuls zur Spannung Null. Die negative Flanke des Eingansimpulses erzeugt in gleicher Weise einen negativen Impuls. Die Länge des positiven und des negativen Impulses ist allein durch die Laufzeit der elektrischen Leitung $L_K$ bestimmt. So können elektrische Impulse einer genauen Länge erzeugt werden.

In Fig. 3 wurde die Spannungsquelle U1 durch eine Stromquelle I1 ersetzt. Der ohmsche Widerstand $R_0$ ist hier parallel zur Stromquelle I1 geschaltet, wodurch sich eine zur Fig. 2 äquivalente Schaltung zrgibt.

Satt einer an ihrem Ausgang kurzgeschlossenen elektrischen Leitung, kann auch eine an ihrem Ausgang offene Leitung $L_0$ zur Erzeugung von elektrischen Impulsen einer genau definierten Länge verwendet werden. Dies ist in Fig. 4 mit der Reihenschltung der elektrischen Leitung $L_0$ und des ohmschen Widerstandes $R_0$ dargestellt, die ebenfalls von der Spannungsquelle U1 angesteuert werden. Da der Reflexionsfaktor einer an ihrem Ausgang offenen Leitung $L_0$ das umgekehrte Vorzeichen einer an ihrem Ausgang kurzgeschlossenen elektrischen Leitung $L_K$ afuweist, ist die Reihenfolge der elektrischen Leitung und des ohmschen Widerstandes $R_0$ vertauscht, um am Ausgang $A_0$ dieselbe Impulsfolgen zu erhalten.

Die Spannungsquelle U1 kann selbstverständlich wiederum in einer dualen Schaltung durch eine Stromquelle ersetzt werden.

Es ist natürlich auch möglich, den am anderen Bauelement der dargestellten Reihenschaltung entstehenden stufenförmigen Impuls auszuwerten.

Anhand der in Fig. 5 dargestellten Zeitdiagramme soll nun die Funktion des Multiplexers MU näher erläutert werden.

An den Eingängen $I_1$ bis $I_4$ liegen vier binäre Digitalsignale $D_1$ bis $D_4$ an. Diese Digitalsignale wechseln alle geleichzeitig mit der Periodendauer $T_0$. Die Verzögerungsdauer des Zeitgliedes T1 kann ein Viertel bis drei Viertel der Periodendauer $T_0$ betragen. Am Ausgang des Zeitgliedes T1 liegt das Digitalsignal $D_4'$ an. An den Takteingängen $I_{11}$ bis $I_{14}$ liegen die Takte $T_1$ bis $T_4$ an. Diese sind jeweils um exakt ein Viertel der Periodendauer $T_0$ gegeneinander versetzt. Die Digitalsignale werden jedoch für eine größere Zeitdauer als $T_0/4$ durchgeschaltet. Zweckmäßigerweise wird für die Takte $T_1$ bis $T_4$ dieselbe Periodendauer $T_0$ gewählt und eine Tastverhältnis von 1:1 verwendet, Als Digitalsignale sollen im Zeitdiagramm der Fig. 5 nur logische Einsen anliegen. In diesem Fall liegen an den Ausgängen der UND-Gatter U1 bis U4 die daegestellten Daten $D_{U1}$ bis $D_{U4}$ an. Durch die Reihenschaltung der ohmschen Widerstände $R_1$ bis $R_4$ mit den elektrischen Leitungen $L_{K1}$ und $L_{K4}$ werden die Impulse $D_{01}$ bis $D_{04}$ erzeugt, die an den Eingängen des ODER-Gatters OR anliegen. Durch das ODER-Gatter OR werden nur die positiven Impulse ausgewertet, während die negativen Impulse unberücksichtigt bleiben. Am Ausgang $A_M$ des ODER-Gatter OR liegen die zusammengefaßten Digitalsignale als Multiplexsignal an.

Durch die erste Kippstufe K1 werden diese Daten entzerrt. Der am Takteingang dieser Kippstufe anliegende Takt $T_5$ weist eine Periodendauer $T_1$ auf, die exakt einem Viertel der Periodendauer $T_0$ entspricht. Mit diesem Takt $T_5$ werden die am D-Eingang der ersten Kippstufe anliegenden multiplexten Daten jeweils in der Bitmitte abgetastet.

Das ODER-Gatter OR und die erste Kippstufe $K_1$ müssen als einzige Logikbausteine für die höchste vorkommende Datenrate ausgelegt sein.

Werden mehr als vier Digitalsignale in einem Multiplexer zusammengefaßt, dann müssen selbstverständlich auch die entsprechenden Takte und Taktverhältnisse gewählt werden.

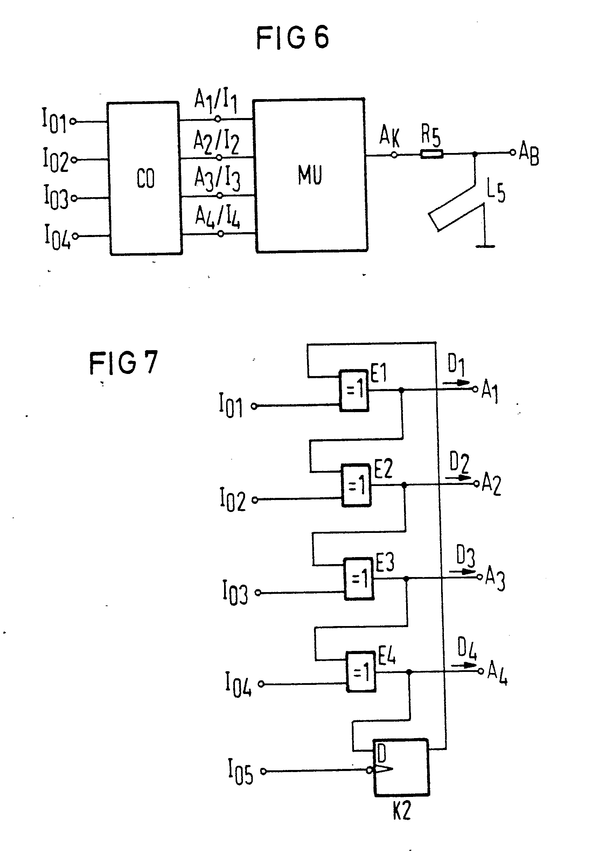

Bei vielen Anwendungsfällen ist es notwendig, einen gleichstromfreien Code auszusenden. Eine derartige Anordnung ist in Fig. 6 dargestellt. An den Ausgang der ersten Kippstufe $K_1$ ist eine aus einem ohmschen Widerstand $R_5$ und aus einer elektrischen Leitung $L_5$ bestehende Schaltungsanordnung zur Erzeugung von positiven und negativen Impulsen angeschlossen. Es wurde hierbei die in Fig. 2 dargestellte Reihenschaltung verwendet. Der Ausgang dieser Schaltungsanordnung ist mit $A_B$ gekennzeichnet. Durch die Schaltungsanordnung $R_5$, $L_5$ wird bei jeder positiven Flanke am Ausgang $A_K$ der erseten Kippstufe $K_1$ ein positiver Impuls und bei jeder negativen Flanke ein negativer Impuls genau definierter Länger erzeugt.

Einer der bekanntesten bipolaren Codes ist der AMI-Code. Bei diesem wird für eine logische Eins des Datensignals abwechselnd ein positiver Impuls und ein negativer Impuls erzeugt. Bei einer logischen Null wird ebenfalls Nullpotential abgegeben. Um diesen Code zu erhalten, muß dem Multiplexer MU ein Codierer CO vorgeschaltet werden, der einen differentiell-binären Code erzeugt. Das gemultiplexte Signal am Ausgang $A_K$ der ersetn Kippstufe liefert dann bei einer logischen Eins der ursprünglichen Datensignale abwechselnd eine positive und negative Flanke und am Ausgang $A_B$ der Schaltungsanordnung $R_5$, $L_5$ abwechselnd einen positiven und negativen Impuls. Die Ausgänge $A_1$ bis $A_4$ des Codierers CO sind mit den entsprechenden Eingängen $I_1$ bis $I_4$ des Multiplexers MU verbunden. An den Eingängen $I_{01}$ bis $I_{04}$ des Codierers liegen die ursprünglichen Digitalsignale an.

Eine einfache Ausführungsform des Codierers ist in Fig. 7 dargestellt. Er besteht aus vier Exclusiv-ODER-Gattern E1 bis E4 und einer zweiten Kippstufe $K_2$. Der Ausgang $A_4$ des vierten Exclusiv-ODER-Gatters E4 ist mit dem D-Eingang der zweiten Kippstufe K2 verbunden. Der Ausgang der zweiten Kippstufe K2 ist mit dem ersten Eingang des ersten Exclusiv-ODER-Gatters E1 verbunden, dem über einen zweiten Eingang $I_{01}$ das erste Digitalsignal zugeführt wird. Der Ausgang des ersten Exclusiv-ODER-Gatters E1 ist mit dem ersten Eingang des zweiten Exclusiv-ODER-Gatters E2 verbunden, dessen zweitem Eingang $I_{02}$ das zweite Digitalsignal zugeführt wird. Dieselbe Kettenschaltung wird bei den Exclusiv-ODER-Gattern E3 und E4 angewendet.

Der zweiten Kippstufe K2 wird über einen Eingang $I_{05}$ ein Arbeitstakt zugeführt, der dem Takt $T_2$ aus Fig. 5 entspricht. Durch die zweite Kippstufe K2 wird das vom Exclusiv-ODER-Gatter E4 abgegebene Digitalsignal $D_4$ um ein Bit verzögert, da es nach dem gleichzeitigen Wechsel der Digitalsignalbits an den Eingängen $I_{01}$ bis $I_{04}$ noch für die Codierung noch zur Verfügung stehen muß. Die Kippstufe wird mit der negativen Flanke des Taktes $T_2$ getriggert.

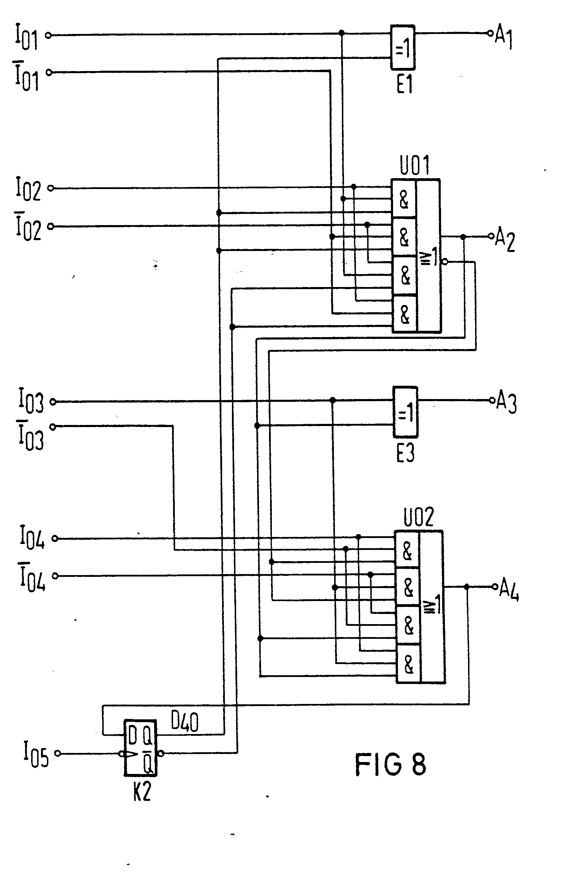

Ein Nachteil dieser Schaltungsanordnung ist ihre relativ lange Laufzeit, da das Eingang $I_{01}$ anliegende Digitalsignal sämtliche Exclusiv-ODER-Gatter durchlaufen muß. Eine Logikschaltung mit kürzerer Laufzeit ist in Fig. 8 dargestellt. Das zweite und das vierte Exclusiv-ODER-Gatter sind durch jeweils eine UND-ODER-Schaltung UO1 und UO2 ersetzt. Jede UND-ODER-Schaltung bildet ein Exclusiv-ODER-Gatter mit drei Eingängen nach. Hierzu sind jeweils vier UND-Gatter mit jeweils drei Eingängen notwendig, denen über weitere Eingänge $\bar{I}_{01}$ bis $\bar{I}_{04}$ auch die invertierten Digitalsignale zugeführt werden. Durch diese Anordnung kommt es nicht zur Addition von Gatter-laufzeit, da beispielsweise dem ersten UND-ODER-Gatter UO1 alle notwendigen Digitalsignale direkt zugeführt werden. Das dritte Exclusiv-ODER-Gatter E3 arbeitet in der neuen beschriebenen Weise, während das zweite UND-ODER-Gatter UO2 die am Ausgang $A_2$ des ersten UND-ODER-Gatters UO1 abgegebene Signal und auch eine hierzu invertiertes Signal mitverwendet.

Ansonsten bietet diese Logikschaltung für den Fachmann keine Besonderheiten, da ihm die Realisierung einer in der Schaltungsanordnung Fig. 7 dargestellten Codierers durch UND-ODER-Gatter keinerlei Probleme bereitet. Es ist vorteilhaft die Bildung des differentiell-binären Codes noch im parallelen Datenstrom durchzuführen, da hier die Anforderungen an die Schaltzeiten der Logikschaltkreise geringer sind.

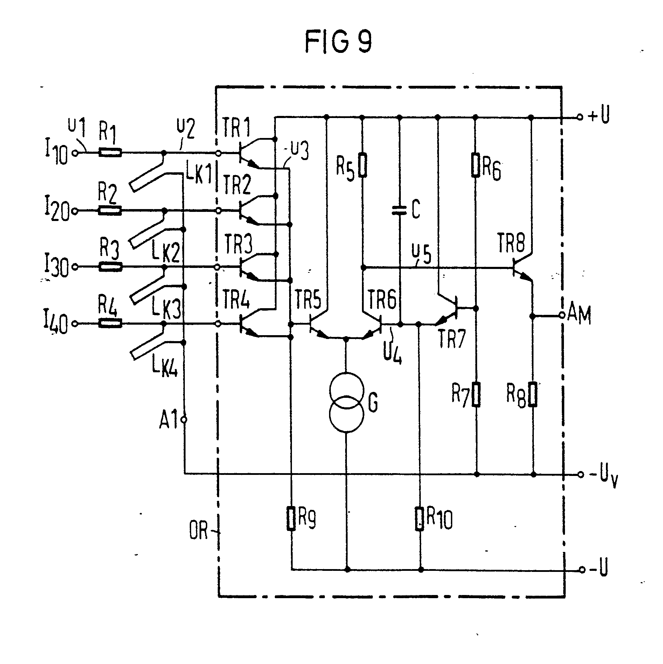

In Fig. 9 ist eine Schaltung des ODER-Gatters OR detailliert dargestellt.

An die Eingänge des ODER-Gatters OR sind die Schaltungsanordnungen zur Erzeugung von Impulsen genau definierter Länge angeschlossen.

Es wurde jeweils die Reihenschaltung eines ohmschen Widerstandes $R_1$ bis $R_4$ und einer an ihrem Ausgang kurzgeschlossenen elektrischen Leitung $L_{K1}$ bis $L_{K4}$ gewählt. Die Eingänge der Reihenschaltungen sind mit $I_{10}$ bis $I_{40}$ bezeichnet. Die Verbindungspunkte der ohmschen Widerstände $R_1$ bis $R_4$ mit den elektrischen Leitungen $L_{K1}$ bis $L_{K4}$ sind mit den Basisanschlüssen von vier Eingangstransistoren TR1 bis TR4 verbunden. Die Kollektoren der Eingangstransistoren sind zusammengeschlossen und an ein (positives) erstes Versorgungspotential +U gelegt. Die Emitter dieser Transistoren sind ebenfalls zusammengeschaltet und mit der Basis eines fünften Transistors TR5 verbunden, der zusammen mit einem sechsten Transistor TR6 einen Differenzverstärker bildet. Über einen ohmschen Widerstand R9 liegt die Basis des fünften Transistors TR5 an einem negativen Potential −U. Als Konstantstromquelle des Differenzverstärkers TR5, TR6 ist ein Generator G eingezeichnet, der die zusammengeschalteten Emitteranschlüsse der Transistoren TR5 und TR6 mit dem negativen Potential −U verbindet. Der Kollektor des fünften Transistors TR5 liegt direkt an dem positiven Potential +U während der Kollektor des sechsten Transistors TR6 über einen ohmschen Widerstand R5 an dieses Potential geschaltet ist. An der Basis des sechsten Transistors TR6 liegt eine Vergleichsspannung $U_4$ an, die von einem siebten Transistor TR7 geliefert wird. An der Basis dieses Transistor liegt ein Spannungsteiler aus den ohmschen Widerständen R6 und R7 zwischen dem positiven Potential +U und einem Vergleichspotential $-U_v$ an. Ein Kondersator C Zwischen der Basis des sechsten Transistors TR6 und dem positiven Potential +U sorgt für eine konstante Gleichspannung. Von dem Kollektor des sechsten Transistors TR6 wird über einen Emitterfolger TR8 mit dem Emitterwiderstand R8 das Ausgangssignal am Anschlußpunkt $A_M$ abgenommen.

Die zweiten Eingänge der an ihrem Ausgang kurzgeschlossenen elektrischen Leitungen $L_{K1}$ bis $L_{K4}$ sind zusammengefaßt und über den Anschlußpunkt A1 ausch an das Vergleichspotential $-U_V$ angeschaltet. Hierdurch wirken sich Schwankungen des Vergleichspotentials $-U_V$ nur minimal auf die Schaltschwellen des ODER-Gatters aus, da sowohl die Vergleichsspannung $U_4$ an der Basis des Tansistors TR6 des Differenzverstärkers als auch das Eingangspotential an den Basisanschlüssen der Eingangstransistoren vom Vergleichspotential $-U_V$ abhängig sind.

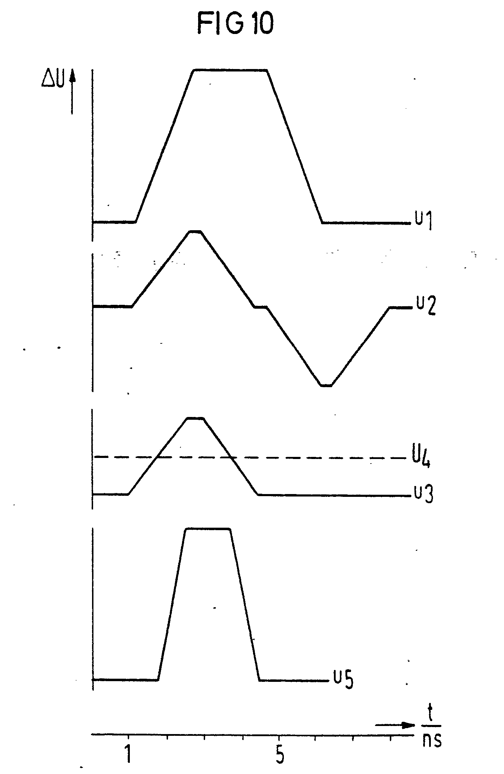

Anhand der Spanungsdiagramme in Fig. 10 wird die Funktion des ODER-Gatter näher erläutert. An den Eingängen $I_{10}$ bis $I_{40}$ liegen die Ausgangssignale der UND-Gatter U1 bis U4 an. Der Spannungsverlauf eines Impulses entspricht dem mit $u_1$ bezeichneten Spannungsverlauf. Die Flankensteilheit der Impulse Muß hierbei berücksichtigt werden. Am Ausgang der Reihenschaltung des ohmschen Widerstandes $R_1$ und der elektrischen Leitung $L_{K1}$ ergibt sich die mit $u_2$ bezeichnete Impulsform. Der negative Spannungsanteile wird von den Eingangstransistoren unterdrückt während der positive Impuls an den Eingang des Transistors TR5 des Differenzverstärkers gelangt. Dieser positive Impuls $u_3$ muß bei einem konstanten Spannungswert $U_4$ möglichst bei der halben Impulsspannung abgetastet werden. Nur dann ergibt sich auch ein Ausgangsimpuls $u_5$ mit einer konstanten Breite.

Um einer möglichst konstante Schaltschwelle zu erhalten, ist deshalb der Differenzverstärker möglichst symmetrisch aufgebaut und auch, wie bereits beschrieben, weitgehend unabhängig von Spanungsschwankungen.

## Patentansprüche

1. Digitalsignal-Multiplexer für hohe Datenraten mit UND-Gattern (U1 bis U4), deren Eingängen ($I_1$ bis $I_4$) jeweils ein Datensignal (D1 bis D4) zugeführt wird und deren zweiten Eingängen phasenverschobene Takte ($T_1$ bis $T_4$) zum Durchschalten der Datensignale (D1 bis D4) zugeführt sind, und mit einem ODER-Gatter (OR), dessen Eingängen die Ausgangssignale der UND-Gatter (U1 bis U4) zugeführt sind, dadurch gekennzeichnet, daß zwischen den Ausgängen der UND-Gatter (U1 bis U4) und den Eingängen des ODER-Gatters (OR) jeweils ein Impulsformernetzwerk mit einem ohmschen Widerstand ($R_1$ bis $R_4$) und einer elektrischen Leitung ($L_{K1}$ bis $L_{K4}$) vorgesehen ist, deren Wellenwiderstand betragsmäßig dem Widerstand des ohmschen Widerstandes ($R_1$ bis $R_4$) entspricht, daß jeweils die Eingangsanschlüsse (EL1, EL2) der elektrischen Leitung in Serie oder parallel zu dem ohmschen Widerstand geschaltet sind, daß die Ausgangsanschlüsse (A1, A2) der elektrischen Leitung offen oder kurzgeschlossen sind und daß digitale Impulse einer vorgegebenen Dauer am Ausgang ($A_0$) des Impulsformernetzwerks durch Überlagerung eines Eingangsimpuls und eines am Ende der elektrischen Leitung reflektierten Impulses erzeugt werden, wobei die Länge der elektrischen Leitung die Dauer der digitalen Impulse bestimmt.

2. Digitalsignal-Multiplexer nach Anspruch 1, dadurch gekennzeichnet, daß als Impulsformernetzwerk zur Erzeugung von digitalen Impulsen einer vorgegebenen Länge eine Reihenschaltung eines ohmschen Widerstandes ($R_0$) und einer an ihren Ausgangsanschlüssen kurzgeschlossenen elektrischen Leitung ($L_K$) vorgesehen ist (Fig. 2).

3. Digitalsignal-Multiplexer nach Anspruch 1, dadurch gekennzeichnet, daß als Impulsformernetzwerk zur Erzeugung von digitalen Impulsen einer vorgegebene Länge die Reihenschaltung einer an ihren Ausgangsanschlüssen offenen elektrischen Leitung ($L_0$) und eines ohmschen Widerstandes ($R_0$) vorgesehen ist (Fig. 4).

4. Digitalsignal-Multiplexer nach Anspruch 1, dadurch gekennzeichnet, daß bei einem Hochohmigen Ausgang des UND-Gatters (U1—U4) als Impulsformernetzwerk zur Erzeugung von digitalen Impulsen einer vorgegebenen Länge eine Parallelschaltung eines ohmschen Widerstandes ($R_0$) und einer an ihren Ausgangsanschlüssen (A1, A2) kurzgeschlossenen ($L_K$) oder offenen elektrischen Leitung ($L_0$) (Fig. 3).

5. Digitalsignal-Multiplexer nach einem der vorhergehenden Ansprüche, dadurch gekennzeichnet, daß als elektrische Leitung ($L_{K1}$—$L_{K4}$, $L_0$, $L_K$) eine Koaxialleitung vorgesehen ist.

6. Digitalsignal-Multiplexer nach einem der vorhergehenden Ansprüche 1—4 dadurch gekennzeichnet, daß als elektrische Leitung ($L_{K1}$—$L_{K4}$, $L_0$, $L_K$) eine bifilar gewickelte Spule vorgesehen ist.

7. Digitalsignal-Multiplexer nach Anspruch 1, dadurch gekennzeichnet, daß als ODER-Gatter Eingangstransistoren (TR1—TR4) vorgesehen sind, deren Kollekturen zusammengeschaltet sind und an ein erstes Versorgungspotential (+U) angeschlossen sind, daß die Emitter der Eingangstransistoren · ebenfalls zusammengeschaltet sind und an den ersten Eingang eines Differerzverstärkers (TR5, TR6, G) angeschlossen sind, daß dem zweiten Eingang des Differenzverstärkers eine von einem Vergleichspotential ($-U_V$) abhängige Vergleichsspannung zugeführt wird und daß den Basisanschlüssen der Eingangstransistoren (TR1—TR4) dasselbe Vergleichspotential ($-U_V$) zugeführt wird.

8. Digitalsignal-Multiplexer nach einem der vorhergehenden Ansprüche, dadurch gekennzeichnet, daß dem Multiplexer (MU) eine Logikschaltung (CO) zur Bildung eines differentiell-binären Codes vorgeschaltet ist und daß der Ausgang ($A_K$) des Multiplexers (MU) an eine aus einem Widerstand ($R_5$) und einer elektrischen Leitung ($L_5$) bestehenden Schaltungsanordnung zur Erzeugung eines bipolaren Impulses angeschlossen ist (Fig. 6).

9. Digitalsignal-Multiplexer nach Anspruch 8, dadurch gekennzeichnet, daß eine Logikschaltung zur Erzeugung des differentiell-binären Codes für vier Digitalsignale mit vier Gatterschaltungen (E1, UO1, E3, UO2) zur Realisierung von Exclusiv-ODER-Funktionen vorgesehen sind, daß der Ausgang der vierten Gatterschltung (UO2) mit dem Eingang einer zweiten Kippstufe (K2) verbunden ist, daß den Eingängen der vier Gatterschaltungen jeweils ein Bit des ursprünglichen Digitalsignals zugeführt wird, daß als erste Leiterschaltung ein Exclusiv-Oder-Gatter (E1) vorgesehen ist, dessen zweiter Eingang mit dem Ausgang der zweiten Kippstufe (K2) verbunden ist, daß Eingänge der zweiten Gatterschaltung (UO1) direkt mit den Ausgägen der zweiten Kippstufe (K2) verbunden und mit dem ersten und dem zweiten ursprünglichen Digitalsgnal über eine Exclusiv-ODER-Funktin direkt verknüpft sind, daß als dritte Gatterschaltung ebenfalls ein Exclusiv-ODER-Gatter (E3) vorgesehen ist, dessen, zweiter Eingang mit dem Ausgang (A2) der zweiten Gatterschaltung (UO1) verbunden ist, und daß Eingänge der vierten Gatterschaltung mit dem Ausgang (A2) oder einem hierzu invertierten Ausgang verbunden sind.

## Revendications

1. Multiplexeur de signaux numériques pour débits élevés de données, comprenant des portes ET (U1 à U4), aux entrées ($I_1$ à $I_4$) de chacune desquelles est amené un signal de données (D1 à D4) et aux secondes entrées desquelles sont amenées des impulsions d'horloge ($T_1$ à $T_4$) déphasées pour la transmission des signaux de données (D1 à D4), ainsi qu'une porte OU (OR) aux entrées de laquelle sont amenés les signaux de sortie des portes ET (U1 à U4), caractérisé en ce qu'un réseau conformateur d'impulsions, possédant une résistance ohmique (R₁ à R₄) et une ligne électrique (L_K1 à L_K4), est prévu entre la sortie de chacune des portes ET (U1 à U4) et les entrées de la porte OU (OR), réseau dont l'impédance d'onde correspond, quant à la valeur, à la résistance ohmique (R₁ à R₄), que les bornes d'entrée (EL1, EL2) de la ligne électrique sont connectées en série avec la résistance ohmique ou parallèlement à celle-ci, que les bornes de sortie (A1, A2) de la ligne électrique sont ouvertes ou court-circuitées et que des impulsions numériques d'une durée préfixée sont engendrées à la sortie (A₀) du réseau conformateur d'impulsions par superposition d'une impulsion d'entrée et d'une impulsion réfléchie à l'extrémité de la ligne électrique, la longueur de la ligne électique déterminant la durée des impulsions numériques.

2. Multiplexeur selon la revendication 1, caractérisé en ceu le réseau conformateur d'impulsions pour produire des impulsions numériques d'une durée prefixée est constitué par le montage en série d'une résistance (R₀) et d'une ligne électrique (L_K) court-circuitée à ses bornes de sortie (Fig. 2).

3. Multiplexeur selon la revendicaiton 1, caractérisé en ce que le réseau conformateur d'impulsions pour produire des impulsions numériques d'une durée préfixée est constitué par le montage en série d'une ligne électrique (L₀), ouverte à ses bornes de sortie, et d'une résistance ohmique (R₀) (Fig. 4).

4. Multiplexeur selon la revendiation 1, caractérisé en ce que, au cas où la porte ET (U1—U4) présente une sortie de haute valeur ohmique, le réseau conformateur d'impulsions pour produire des impulsions numériques de durée préfixée est constitué par le montage en parallèle d'une résistance ohmique (R₀) et d'une ligne électrique (L_K) court-circuitée à ses bornes de sortie ou d'une ligne électrique (L₀) ouverte à ces bornes (Fig. 3).

5. Multiplexeur selon une des revendications précédentes, caractérisé en ce que la ligne électrique (L_K1—L_K4, L₀, L_K) est une ligne coaxiale.

6. Multiplexeur selon une des revendications 1—4 précédentes, caractérisé en ce que la ligne électrique (L_K1—L_K4, L₀, L_K) est constituée par une bobine à enroulement bifilaire.

7. Multiplexeur selon la revendication 1, caractérisé en ce que les portes OU sont constituées par des transistors d'entrée (TR1—TR4) dont les collecteurs sont connectés ensemble et sont reliés à un premier potentiel d'alimentation (−U), que les émetteurs des transistors d'entrée sont également connectés ensemble et sont reliés à la première entrée d'un amplificateur différenciateur (TR5, TR6, G), qu'une tension de comparaison dépendante d'un potentiel de comparaison (−U_v) est appliquée à la deuxième entrée de l'amplificateur différenciateur et que le même potentiel de comparaison (−U_v) est appliqué aux bornes de base des transistors d'entrée (TR1—TR4).

8. Multiplexeur selon une des revendications précédentes, caractérisé en ce que le multiplexeur (MU) est précéde d'un circuit logique (CO) pour la formation d'un code différentiel-binaire et que la sortie (A_K) du multiplexeur (MU) est connectée à un montage, formé d'une résistance (R₆) et d'une ligne électique (L₅), pour produire une impulsion bipolaire (Fig. 6).

9. Multiplexeur selon la revendication 8, caractérisé en ce qu'il comprend un circuit logique, destiné à produire le code différientiel-binaire pour quatre signaux numériques, qui comprend quatre circuits de portes (E1, UO1, E3, UO2) pour la réalisation de fonctions OU-exclusif, que la sortie du quatrième circuit de portes (UO2) est reliée à l'entrée d'un second basculeur (K2), qu'un bit du signal numérique original est appliqué à l'entrée de chacun des quatre circuits de portes, que le premier circuit de porte est formé par une porte OU-exclusif (E1) dont la deuxième entrée est reliée à la sortie du second basculeur (K2), que des entrées du deuxième circuit de portes (UO1) sont reliées directement aux sorties du second basculeur (K2) et sont combinées directement par une fonction OU-exclusif avec le premier et le second signal numérique original, que le troisième circuit de porte est également formé par une porte OU-exclusif (E3) dont la deuxième entrée est reliée à la sortie (A2) de deuxième circuit de portes (UO1) et que des entrées du quatrème circuit de portes sont reliées à la sortie (A2) du deuxième circuit de portes ou à une sortie inversée par rapport à celle-ci.

**Claims**

1. A digital signal multiplexer for high data rates comprising AND-gates (U1 to U4), whose inputs (I₁ to I₄) are respectively supplied with a data signal (D1 to D4) and whose second inputs are supplied with phase-shifed clock pulses (T₁ to T₄) for switching the data signals (D1 to D4), and comprising an OR-gate (OR), whose inputs are supplied with the output signals of the AND-gates (U1 to U4), characterised in that between the outputs of the AND-gates (U1 to U4) and the inputs of the OR-gates (OR) is respectively arranged a pulse forming network having an ohmic resistor (R₁ to R₄) and an electrical conductor (L_K1 to L_K4), whose characteristic impedance corresponds to the resistance of the ohmic resistor (R₁ to R₄) in terms of value, that the input terminals (EL1, EL2) of the electrical conductor are connected to the ohmic resistor in series or in parallel, that the output terminals (A1, A2) of the electrical conductor are open or short-circuited, and that digital pulses of a predetermined duration are produced at the output (A₀) of the pulse forming network by superimposition of an input pulse and a pulse reflected at the end of the electrical conductor, where the length of the electrical conductor determines the duration of the digital pulses.

2. A digital signal multiplexer as claimed in claim 1, characterised in that a series connection of an ohmic resistor ($R_0$) and an electrical conductor ($L_K$) which is short-circuited at its output terminals, is provided as a pulse forming network for the generation of digital pulses of a predetermined length (Fig. 2).

3. A digital signal multiplexer as claimed in claim 1, characterised in that a series connection of an electrical conductor ($L_0$), which is open at its output terminals, and an ohmic resistor ($R_0$) is provided as a pulse forming network for the generation of digital pulses of a predetermined length (Fig. 4).

4. A digital signal multiplexer as claimed in claim 1, characterised in that in the case of a high-ohmic output of the AND-gate (U1 to U4), a parallel connection of an ohmic resistor ($R_0$) and an electrical conductor ($L_0$) which at its output terminals (A1, A2) is short-circuited ($L_K$) or open, is arranged as a pulse forming network for the production of digital pulses of a predetermined length (Fig. 3).

5. A digital signal multiplexer as claimed in one of the preceding claims, characterised in that a coaxial line is provided as an electrical conductor ($L_{K1}$—$L_{K4}$, $L_0$, $L_K$).

6. A digital signal multiplexer as claimed in one of the preceding claims, characterised in that a bifilarly wound coil is provided as an electrical conductor ($L_{K1}$—$L_{K4}$, $L_0$, $L_K$).

7. A digital signal multiplexer as claimed in claim 1, characterised in that OR-gates are provided as input transistors (TR1 to TR4) whose collectors are switched together and connected to a first supply potential ($-U$), that the emitters of the input-transistors are likewise switched together and connected to the first input of a difference amplifier (TR5, TR6, G), that the second input of the difference amplifier is supplied with a comparison voltage which is dependent upon a comparision potential ($-U_V$), and that the base terminals of the-input transistors (TR1—TR4) are fed with the same comparison potential ($-U_V$).

8. A digital signal multiplexer as claimed in one of the preceding claims, characterised in that the multiplexer (MU) is preceded by a logic circuit (CO) for the production of a differential-binary code and that the output ($A_K$) of the multiplexer (MU) is connected to a circuit arrangement which comprises a resistor ($R_5$) and an electrical conductor ($L_5$) and serves to produce a bipolar pulse (Fig. 6).

9. A digital signal multiplexer as claimed in claim 8, charcterised in that there is arranged a logic circuit for the production of a differential-binary code for four digital signals with four gate circuits (E1, UO1, E3, UO2) for the realisation of exclusive-or-functions, that the output of the fourth gate circuit (UO2) is connected to the input of a second flip-flop (K2), that the inputs of the four gate circuits are respectively supplied with a bit of the original digital signal, that an exclusive-OR-gate (E1) is provided as a first conductor circuit, whose second input is connected to the output of the second flip-flop (K2), that inputs of the second gate circuit (UO1) are directly connected to the outputs of the second flip-flop (K2) and are directly linked with the first and the second original digital signal by means of an exclusive-OR-function, that an exclusive-OR-gate (E3) is provided as a third gate circuit, whose second input is connected to the output (A2) of the second gate circuit (UO1), and that inputs of the fourth gate circuit are connected to the output (A2) or an output inverted thereto.

FIG 1

FIG 2

FIG 3

FIG 4

FIG 5

# FIG 6

$I_{01}$

$I_{02}$

$I_{03}$

$I_{04}$

CO

$A_1/I_1$

$A_2/I_2$

$A_3/I_3$

$A_4/I_4$

MU

AK

$R_5$

$A_B$

$L_5$

# FIG 7

$I_{01}$

=1 E1

$D_1$ $A_1$

$I_{02}$

=1 E2

$D_2$ $A_2$

$I_{03}$

=1 E3

$D_3$ $A_3$

$I_{04}$

=1 E4

$D_4$ $A_4$

$I_{05}$

D

K2

FIG 8

0 087 153

FIG 9

# FIG 10